# DEMANDE DE BREVET EUROPEEN

(11) **EP 1 331 729 A1**
(43) Date de publication de la demande: **30.07.2003**
(21) Numéro de dépôt: 03290120.9
(22) Date de dépôt: 17.01.2003
(51) Int. Cl.: H03F 1/32

(54) **Amplificateur linéaire à précorrection**

(30) Priorité: 21.01.2002 FR 0200696
(71) Demandeur: Evolium S.A.S., 75008 Paris (FR)
(72) Inventeur: Dartois, Luc, 78955 Carrieres sous Poissy (FR)
(74) Mandataire: El Manouni, Josiane

(57) **Abrégé**

L'invention concerne la préparation de signaux (respectivement X et Y) destinés à être comparés pour établir une pré-distorsion sur l'entrée d'un amplificateur (12), les signaux comprenant un signal (X) avant amplification et un signal (Y) après amplification par ledit amplificateur. Cette préparation comprend un alignement temporel (22) entre les signaux avant amplification et après amplification (respectivement X et Y) avant de les utiliser pour établir ladite pré-distorsion.

De préférence, l'invention agit en deux étapes, respectivement d'alignement temporel grossier, à laquelle on soumet le signal (X) avant amplification à un retard composé d'un nombre entier de premières unités de temps, et d'alignement temporel fin, à laquelle on détermine une valeur de retard ou d'avance, d'une fraction de la première unité de temps.

## Description

L'invention concerne le domaine du traitement du signal, et plus particulièrement dans le cadre de la correction de la distorsion produite par une chaîne d'amplification. Cette correction implique une comparaison des caractéristiques du signal en sortie avec le signal d'origine en entrée de la chaîne d'amplification, afin de déterminer la distorsion qu'elle produit. Cela permet de calculer en réponse une pré-distorsion inverse à imprimer sur le signal d'entrée tendant à annuler cette distorsion, et donc d'améliorer la linéarité et le rendement électrique de la chaîne d'amplification.

L'invention part du constat que le retard occasionné par la chaîne d'amplification, qui fait que la comparaison ne porte pas sur le signal et sa réplique exacte (si on ignore la distorsion intrinsèque de la chaîne), entraîne une erreur non-négligeable et une limitation de principe dans le calcul de la pré-distorsion.

Or, les techniques de pré-distorsion actuelles n'abordent pas ce problème d'erreur lié au retard entre les signaux intervenant dans la comparaison.

La comparaison des signaux étant généralement réalisée par des techniques numériques, il est nécessaire de numériser au moins le signal analogique en sortie de chaîne d'amplification. Ce signal de sortie numérisé à un instant donné t0 est la réplique (distordue plus ou moins par l'amplificateur) du signal en amont de la chaîne au temps t0-δ, où δ est le retard occasionné par la chaîne.

On note par ailleurs que le retard n'est pas fixe, mais peut évoluer avec le vieillissement de la chaîne, sa température, le signal amplifié, la puissance, la bande de fréquence utilisée etc., ce qui rendrait peu efficace une correction par un simple décalage temporel fixe du signal de comparaison provenant du côté amont de la chaîne d'amplification (signal de référence)

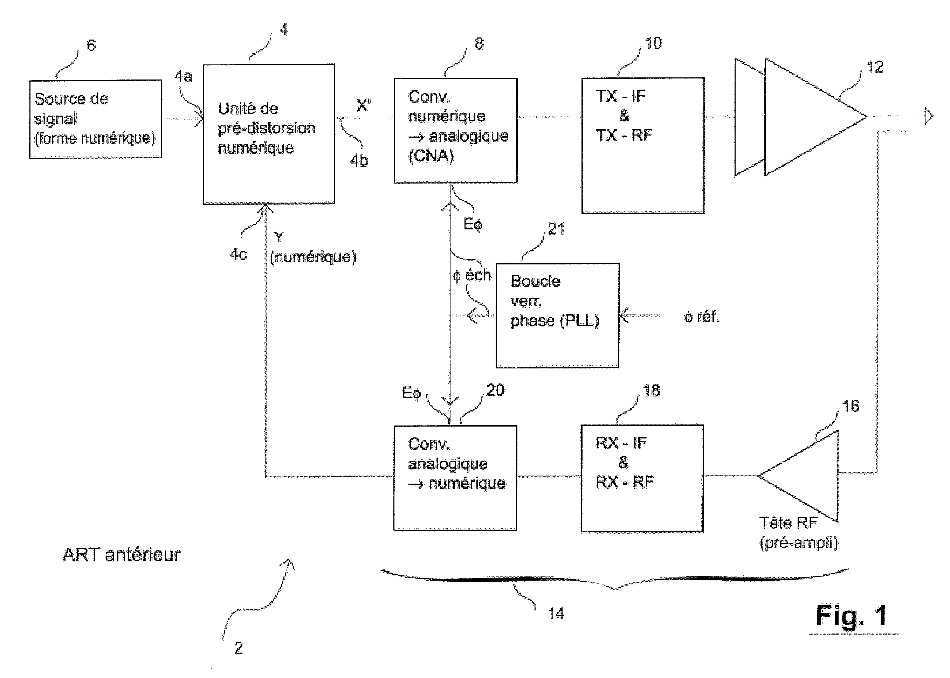

La figure 1 est un schéma simplifié des éléments principaux intervenant dans une chaîne classique d'amplification pour un émetteur hertzien avec correction de non-linéarité par pré-distorsion. L'ensemble 2 comprend une unité de pré-distorsion numérique 4 qui reçoit à une première entrée 4a un signal numérique X destiné à être amplifié, en l'occurrence d'une source de modulation numérique 6. L'unité 4 ajoute à ce signal numérique X une pré-distorsion qui le modifie en signal à pré-distorsion X', fourni en sortie 4b. Ce signal X' est ensuite converti en forme analogique par un convertisseur numérique-analogique (CNA) 8 dont la sortie alimente un étage de transposition en élévation de fréquence pour émission (TX-IF et TX-RF) 10 qui attaque l'amplificateur de puissance 12 relié à une antenne d'émission (non représentée).

Le signal de sortie Y de l'amplificateur de puissance 12 est soumis à un rebouclage (boucle 14) sur deuxième entrée 4c de l'unité de pré-distorsion 4, permettant de réaliser la comparaison. A cette fin, la boucle comprend une tête RF (radio fréquence) 16 dont l'entrée reçoit le signal de sortie de l'amplificateur de puissance 12, le produisant sous une forme exploitable à un étage de transposition en réduction de fréquence pour réception (XR-IF et XR-RF) 18, qui a une fonction inverse de l'étage de transposition 10 (même si les fréquences intermédiaires ne sont pas les mêmes). La sortie de l'étage de transposition 18 est numérisée par un convertisseur analogique-numérique (CAN) 20 qui fournit le signal Y numérisé de la deuxième entrée 4c de l'unité de pré-distorsion.

Les convertisseurs CNA et CAN 8 et 20 sont cadencés par un signal ϕéch à des entrées d'horloge respectives Eϕ. Le signal ϕéch fixe la périodicité de chaque conversion de valeur numérique instantanée du signal X pour le convertisseur CNA, et la périodicité de chaque numérisation de la valeur analogique instantanée du signal détecté en sortie de l'amplificateur de puissance 12, soit le taux d'échantillonnage. Dans l'exemple, le signal ϕéch est fourni communément aux deux convertisseurs CNA et CAN 8 et 20 par une boucle de verrouillage en phase 21 (désignée ci-après PLL, de l'acronyme anglo-saxon "phase locked loop") alimenté par une horloge de référence ϕréf.

On note que les signaux X et Y comparés par l'unité de pré-distorsion sont sujets à des décalages temporels variables qui peuvent être supérieurs à la période de l'horloge ϕéch, et dont les valeurs exactes ne correspondent pas à un nombre entier de périodes de cette horloge.

Dans l'état de l'art, la sortie Y en bande de base du convertisseur CAN 20 est comparé directement au signal X, sans plus de précaution.

Il en résulte des limitations de performance par l'étalonnage intrinsèque en usine de l'alignement des phases et surtout de l'alignement temporel de l'échantillonnage entre l'émission dans le convertisseur CNA 8 et la réception dans le convertisseur CAN 20, ainsi que par les temps de propagation inhérents à la chaîne, qui sont non négligeables et sujets à des variations, notamment en raison de la présence de filtres analogiques. Si les décalages temporels au niveau des signaux sous forme numérique peuvent être maîtrisés, le problème est beaucoup plus délicat lorsqu'ils se situent au niveau analogique.

Ce défaut d'alignement temporel est particulièrement préjudiciable pour l'obtention de bonnes performances de pré-distorsion à un coût raisonnable pour les stations émettrices modernes, telles que celles employées dans les systèmes cellulaires de troisième génération. Ces derniers utilisent en tant qu'interface hertzien un codage du type dit "à accès multiples à répartition par codes" (AMRC, également connu par l'acronyme anglo-saxon CDMA, de "code division multiple access"). Pour des raisons de coûts et de dimensionnement, les stations d'émission-réception de base (également connus par l'acronyme anglo-saxon BTS, de "base transceiver station") n'utiliseront qu'un seul amplificateur de puissance de transmission et de radio 12 pour émettre les signaux de tous les utilisateurs pour une ou plusieurs porteuses. Dans ce contexte, le terme transmission entend la chaîne complète d'émission dans la station de base, qui comprend à la fois la partie numérique de traitement de l'information et du signal, et la partie purement analogique comprenant notamment l'amplificateur de puissance ; la partie radio comprend alors ce dernier maillon de la chaîne.

On pourrait corriger l'erreur dans la pré-distorsion occasionnée par ce décalage temporel en utilisant des techniques algorithmiques, mais au prix de moyens de calculs lourds. Qui plus est, ces techniques seraient basées sur des approximations et extrapolations qui imposeraient un limitation fondamentale à la précision.

Une utilisation optimale des nouvelles techniques de pré-distorsion alliée à des techniques d'écrêtage permettent d'obtenir des rendements d'amplificateur de puissance jusqu'à 15 à 17%.

Cela représente une avancée significative par rapport aux techniques classiques d'amplification (également connues par le terme anglo-saxon de "feedforward"), dont le rendement est limité aux alentours de 8%. Elle permet par ailleurs une réduction de coûts et, par un traitement numérique, le remplacement des techniques complexes utilisées dans les étages analogiques et radiofréquence de puissance élevée.

Cependant, pour faire face aux nombreux et différents types d'amplificateurs et transistors de puissance et minimiser, voire éviter, les calibrations en usine, le système de pré-distorsion doit être adaptatif afin de suivre et de corriger de manière dynamique les changements de fonction de transfert des d'amplificateurs de puissance, notamment les variations de non-linéarité sur la bande de fréquence, le nombre de porteuses, la température, le vieillissement, les effets de mémoire (rémanence)...).

Les méthodes les plus performantes et rapides sont basées sur des tables de conversion qui permettent de construire l'inverse des non-linéarités d'un amplificateur de puissance afin de l'appliquer sur le signal de modulation et ainsi reproduire en sortie d'amplificateur de puissance le signal d'origine voulu avec le meilleur masquage de spectre sur les canaux voisins.

Toutefois, et quelques soient leurs variantes, les algorithmes utilisés pour mettre à jour la table de pré-distorsion sont basés sur des récepteurs de large bande et très linéaires offrant une bonne copie du signal émis. La mise à jour de la pré-distorsion est basée sur une comparaison, c'est-à-dire une corrélation entre le signal entrant et le signal sortant. Plus la bande d'émission et la bande à linéariser sont grandes (au moins trois à cinq fois la bande de transmission instantanée), plus le gain de linéarisation est lié directement à la précision de cette comparaison. La plupart de ces méthodes, basées sur des algorithmes de la classe LMS (de l'acronyme anglo-saxon pour "least mean squares", soit la technique des moindres carrés moyens), sont relativement insensibles à la quadrature et au gain des signaux à comparer. Cependant, le problème majeur est la précision temporelle des retards entre les signaux comparés. En fait, le problème est en tout point identique à celui du calage de retards en bande large pour un ampli "feedforward" sauf qu'on se situe dans le monde numérique pour la predistorsion. Dans ce cas, le problème est d'autant plus difficile que la bande à linéariser est large. En pratique, si l'on souhaite obtenir une amélioration en linéarité de l'ordre de 25dB pour un amplificateur UMTS à trois ou quatre porteuses dans une bande de 60MHz, on doit avoir un décalage temporel entre les échantillons émis et mesurés du signal qui ne dépasse pas 10 picosecondes. Cette précision ne peut être obtenue par un étalonnage en usine en raison des variations encore plus importantes dans les dérives de phase des horloges et des variations dans l'ensemble de la chaîne de transmission et de réception.

Le problème à résoudre est de trouver des méthodes pour suivre et mesurer l'alignement temporel de manière dynamique et la corriger avec des moyens simples, basées de préférence sur des techniques numériques à bas coûts.

Dans l'état de la technique, on utilise un émetteur à haut rendement et, en tandem, un écrêtage et une pré-distorsion numérique. Les techniques numériques de pré-distorsion les plus connues sont basées sur l'asservissement temporel, c'est-à-dire un récepteur à bande large de haute linéarité. Elles utilisent de préférence un sous-échantillonnage en fréquence intermédiaire (afin d'éviter des défauts d'appairage de gain et de quadrature et de composante continue) pour alimenter des algorithmes LMS servant à mettre à jour la table de pré-distorsion.

On s'assure que l'alignement temporel ne soit pas perturbé par d'éventuelles non-concordances de gain ou de niveau de signal, ou de quadrature (dans le plan complexe) entre les deux signaux à comparer. Pour ce qui est de la différence de gain entre les signaux X et Y (cf. figure 1), les méthodes proposées n'y sont pas directement sensibles. Il en est de même pour les défauts de quadrature.

Les algorithmes LMS sont capables de prendre en compte la rotation de phase et la différence de gain entre le signal mesuré et le signal à émettre. Ceci affecte par une valeur complexe constante tous les coefficients complexes dans la table de pré-distorsion. Une telle valeur constante, et en particulier la composante de gain, peut être détectée et éliminée en sachant que normalement, à la puissance d'émission la plus faible, la correction de gain doit être unitaire (module des premières valeurs dans la table de prédistorsion).

Certaines variantes autour de ces méthodes peuvent accroître soit la performance, soit la simplification de la mise en oeuvre, dont:
- la technique dite LMS simplifiée (ou clipped LMS), en réduisant certaines multiplications complexes de mise à jour de coefficients au taux d'échantillonnage à des multiplications de signe sans réduire la vitesse de convergence ou la précision de linéarisation, et
- la pré-distorsion bidimensionnelle pour faire face aux problèmes de bande large, tels que les non linéarités qui varient avec la fréquence instantanée du signal ou la puissance des échantillons précédemment amplifiés (effet mémoire thermique court terme).

Dans tous les cas, l'algorithme est sensible au décalages de composante continue qui doit être éliminée. Cette tâche peut être effectuée aisément par un simple filtre à bande étroite si un convertisseur CAN en bande de base est utilisé dans le récepteur.

Dans l'état de la technique, le problème du bon alignement entre le signal d'entrée et le signal mesuré n'a pas été abordé, ce qui a pour résultat que l'alignement est limité à ±1/2 échantillon, et que l'erreur en termes de différence de signal mesuré n'est réduite qu'en utilisant le taux d'échantillonnage le plus rapide possible par la technologie CAN et en minimisant ainsi l'erreur de décalage. Actuellement, avec environ 80 MSPS et une bande de signal de 15 MHz, la limitation dans le gain de linéarisation adaptatif est dans la plage de 12 à 15dB.

Une autre méthode connue qui peut être envisagée, si on dispose d'une bonne métrique pour mesurer le décalage temporel, consiste à retarder de manière programmable le signal source pour le caler sur le signal issu du récepteur de mesure. On utilise alors un filtre programmable dont la courbe de gain est plate, et le retard est d'une fraction de l'échantillon dans la bande voulue. Cette approche est très coûteuse en multiplicateurs car fonctionnant au rythme d'échantillonnage (filtres à structure de Farrow par exemple, tel que décrit dans le document brevet WO 99/57806).

Au vu de ces problèmes, l'invention a pour objet de produire une technique d'alignement temporel de signaux ayant une origine commune et qui permet, dans une application, de calibrer dynamiquement et d'améliorer les performances de pré-distorsion, mis en oeuvre sous forme numérique, afin d'accroître les performances radio et le rendement électrique de l'amplificateur radio.

La solution de l'invention est à la fois fiable est peu coûteuse pour la réaliser.

Plus précisément, l'invention prévoit, selon un premier objet, un procédé de préparation de signaux destinés à être comparés pour établir une pré-distorsion sur l'entrée d'un amplificateur, les signaux comprenant un signal avant amplification et un signal après amplification par ledit amplificateur,
caractérisé en ce que ladite préparation comprend un alignement temporel entre les signaux avant amplification et après amplification avant de les utiliser pour établir ladite pré-distorsion.

Avantageusement, le procédé comprend :
- une première étape d'alignement temporel grossier, à laquelle on soumet le signal avant amplification à un retard composé d'un nombre entier de premières unités de temps, et on détermine la valeur de ce retard qui produit le signal avant amplification retardé ayant le meilleur alignement temporel avec le signal après amplification, et
- une deuxième étape d'alignement temporel fin, à laquelle on détermine une valeur de retard ou d'avance, d'une fraction de la première unité de temps, à appliquer au signal prélevé après amplification permettant d'obtenir le meilleur alignement temporel avec le signal avant amplification retardé, et on applique cette valeur de retard ou d'avance au signal après amplification,
les signaux ainsi rapprochés en temps étant utilisés pour établir ladite pré-distorsion.

Les signaux avant amplification et après amplification peuvent être présentés sous forme numérique à la première étape d'alignement temporel.

On peut déterminer le signal avant amplification retardé ayant le meilleur alignement temporel et/ou la fraction de la première unité de temps par analyse de points de corrélation entre d'une part le signal avant amplification retardé et d'autre part le signal après amplification de l'amplificateur, ledit signal avant amplification retardé ayant le meilleur alignement temporel étant identifié comme celui offrant les points de corrélation les plus élevés.

L'analyse de points de corrélation peut alors s'effectuer sur plusieurs formes retardées distincte du signal avant amplification retardé, présentées en parallèle pour ladite analyse, le signal avant amplification retardé ayant le meilleur alignement temporel étant sélectionné parmi ces formes distinctes du signal avant amplification retardé.

L'analyse de points de corrélation peut se faire sur la base de la représentation complexe d'au moins l'un des signaux) soumis à la corrélation, par exemple sur la base de la représentation complexe, i.e. des parties réelle et imaginaire, dudit signal avant amplification retardé et sur la représentation réelle seulement du signal après amplification.

Dans le mode de réalisation, on numérise le signal après amplification, avant la première étape, à une première fréquence d'échantillonnage en relation harmonique avec celle du signal avant amplification.

On peut définir, pour le signal avant amplification retardé ayant le meilleur alignement temporel, une courbe de corrélation à l'aide d'au moins trois points de corrélation, dont un premier point de corrélation correspondant à la valeur de corrélation la plus élevée des points de corrélation, et un deuxième et un troisième points de corrélation respectivement de part et d'autre du premier point de corrélation, le rapprochement des instants d'échantillonnage des signaux lors de la seconde étape d'alignement phase d'alignement temporel étant réalisé en :
- retardant l'instant d'échantillonnage du signal après amplification de l'amplificateur relativement au signal avant amplification retardé si le deuxième point de corrélation présente un niveau de corrélation inférieur à celui de troisième point de corrélation, et en
- avançant l'instant d'échantillonnage du signal après amplification de l'amplificateur relativement au signal avant amplification retardé si le deuxième point de corrélation présente un niveau de corrélation supérieur à celui de troisième point de corrélation,
ou inversement,
de manière à converger vers un niveau de corrélation sensiblement égal entre les deuxième et troisième points de corrélation.

La détermination de corrélation peut être établie en ne prenant en compte que les signes d'une part du signal avant amplification retardé et d'autre part du signal après amplification de l'amplificateur, ladite corrélation étant basée sur des calculs de coïncidence de signes entre ces deux signaux.

De préférence, on numérise le signal après amplification à une fréquence d'échantillonnage contrôlée en phase, la deuxième étape consistant à faire varier cette phase d'échantillonnage sélectivement pour accroître l'alignement temporel du signal avant amplification retardé ayant le meilleur alignement temporel et dudit signal après amplification de l'amplificateur.

Ladite première fréquence d'échantillonnage contrôlée en phase peut être produite en sortie d'une première boucle à verrouillage en phase, la variation étant obtenue en variant de façon impulsionnelle la fréquence de référence de cette boucle.

Avantageusement,on produit la fréquence de référence de la première boucle à verrouillage en phase au moyen d'une seconde boucle à verrouillage en phase, après division de fréquence de sa fréquence de sortie par un nombre diviseur variable, la variation de la fréquence de référence de la première boucle à verrouillage en phase étant produite par changement du nombre pour obtenir ledit rapprochement des phases du signal avant amplification retardé ayant le meilleur alignement temporel et du signal après amplification.

On peut réaliser la conversion numérique-analogique du signal avant amplification avant de la fournir en entrée de ce dernier, la conversion étant cadencée par un signal d'échantillonnage produit en sortie de la seconde boucle de verrouillage en phase.

Selon un deuxième aspect, l'invention concerne un dispositif de préparation de signaux destinés à être soumis à des moyens de pré-distorsion agissant sur l'entrée d'un amplificateur, les signaux comprenant un signal avant amplification et un signal après amplification par ledit amplificateur,
caractérisé en ce qu'il comprend des moyens d'alignement temporel entre les signaux avant amplification et après amplification.

Les aspects optionnels de l'invention présentés dans le cadre du procédé (premier aspect) s'appliquent mutatis mutandis à ce dispositif (deuxième aspect).

Selon un troisième aspect, l'invention concerne une chaîne d'amplification ayant au moins un amplificateur et comprenant des moyens de pré-distorsion acceptant en entrée pour comparaison des signaux respectivement avant et après distorsion par l'amplificateur caractérisé en ce qu'il comprend un dispositif d'alignement temporel selon le deuxième aspect précité fournissant les signaux en entrée pour comparaison.

La chaîne peut être mise en oeuvre pour une l'amplification de puissance linéaire d'un émetteur hertzien large bande, par exemple une bande qui s'établit sur une fréquence de l'ordre de 10 à 100 MHz, par exemple 60 MHz, destinée à l'émission de signaux a porteuses multiples, par exemple pour l'émission en codage du type dit "à accès multiples à répartition par codes" (AMRC) pour la téléphonie mobile.

L'invention sera mieux comprise et les avantages qui en découlent apparaîtront plus clairement à la lecture de la description qui suit des modes de réalisation préférés, donnés purement à titre d'exemples non-limitatifs par référence aux dessins annexés dont :
- la figure 1, déjà décrite, est un schéma bloc simplifié d'une chaîne d'émission à amplification de puissance mettant en oeuvre une correction de non-linéarité par une unité de pré-distorsion numérique selon une technique connue ;
- la figure 2 est un schéma bloc d'une chaîne d'émission semblable à celle de la figure 1, mais comprenant en outre des moyens d'alignement temporel des signaux en amont et après amplification de la chaîne d'amplification, conformément à la présente invention ;
- la figure 3 est un schéma bloc de l'unité d'alignement temporel de la figure 2 et des éléments de la chaîne qu'elle commande ;
- les figures 4a, 4b et 4c sont des diagrammes montrant les relations de corrélations entre les signaux an amont et après amplification de la chaîne d'amplification permettant d'obtenir un réglage fin de leur alignement temporel.

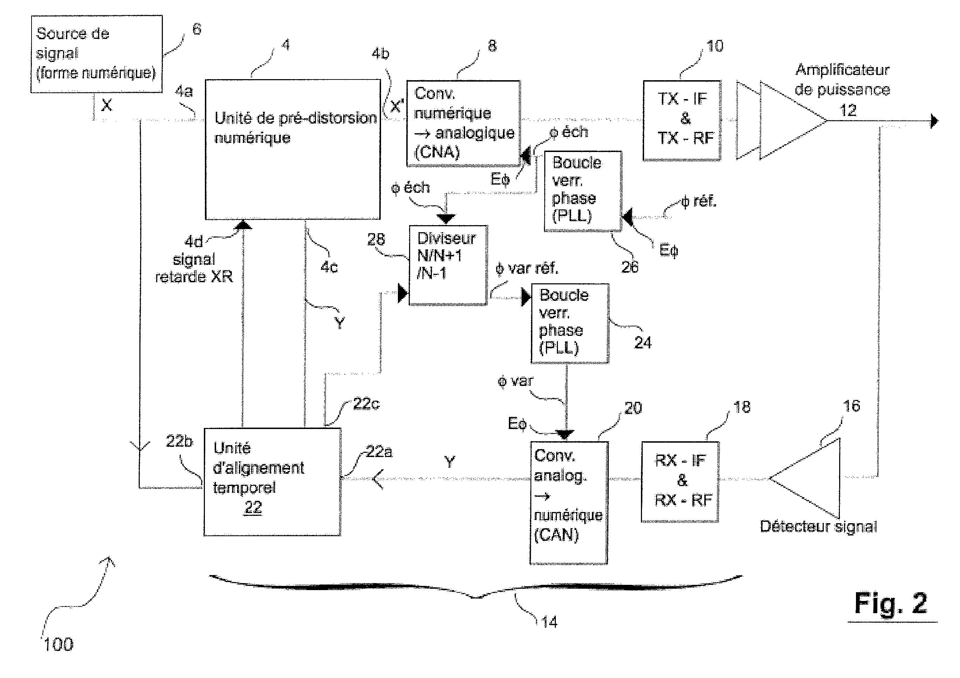

Un mode de réalisation de l'invention dans le contexte d'une chaîne d'amplification avec pré-distorsion est représenté à la figure 2. Dans cette figure, les éléments analogues à ceux de la figure 1 portent les mêmes références et ne seront pas décrits de nouveau par souci de concision.

Dans l'exemple, la source 6 de signal numérique de la chaîne 100 produit un signal composite composé de plusieurs codes et de fréquences, celui ci étant par exemple conforme à la norme 3GTP UMTS. Dans ce cas, une porteuse est la superposition de codes orthogonaux, chacun véhiculant l'information pour un abonné. Dans les techniques modernes, il est souhaité que la chaîne de transmission complète 100, donc d'amplification, soit unique pour une station ou un secteur antenne donné. Cela implique qu'une même chaîne d'amplification sert non seulement pour tous les abonnés d'une même porteuse, mais pour plusieurs porteuses sur le site radio commun. L'un des problèmes posés par cette approche provient du fait que chaque porteuse a un signal qui n'est pas à enveloppe constante. En effet, puisque l'on superpose plusieurs abonnés, il existe une grande variation dans le temps de la puissance instantanée du signal, à la différence d'une modulation de phase ou fréquence classique à enveloppe constante où les puissances instantanées et moyennes sont toujours égales. Ceci oblige à sur dimensionner l'amplificateur de puissance 12 pour avoir une linéarité exploitable avant même la correction de non linéarité, ce qui entraîne des surcoûts d'installation et en consommation d'énergie. Le phénomène et d'autant plus accentué que l'on traite plusieurs porteuses simultanément, car on accroît alors les crêtes maximum du signal possible résultant d'un ensemble de porteuses proches simultanément de leur crête.

Le signal numérique X de la source 6 passe dans l'unité de pré-distorsion numérique 4 d'où il ressort sous forme de signal X' à pré-distorsion. Ce signal X' est présenté en entrée d'un convertisseur numérique analogique 8 (ou éventuellement deux, selon que l'on agit au niveau de bande de base ou en fréquence intermédiaire numérique). La forme analogique du signal X' en sortie de convertisseur et ensuite soumis à une ou plusieurs transpositions de fréquence à l'étage de fréquence intermédiaire et radiofréquence (TX-IF et TX-RF) 10, puis présenté en entrée de l'amplificateur de puissance 12 qui attaque l'antenne de transmission.

La commande dynamique de la pré-distorsion passe par un rebouclage 14 sur une chaîne de mesure à partir du signal de la sortie de l'amplificateur de puissance. Cette chaîne comprend un coupleur directif 16 analogique prélevant une partie du signal de la sortie de l'amplificateur, qui assure une protection directive contre les signaux de même bande de fréquence captés par l'antenne et une adaptation d'impédance. Ce coupleur 16 attaque un étage de changement de fréquence 18, qui correspond à un récepteur effectuant la transposition (XR-IF et XR-RF) inverse de l'étage 10 en amont de l'amplificateur de puissance. Le signal changé en fréquence est numérisé par un convertisseur analogique-numérique (CAN) 20, la numérisation étant réalisée de préférence en fréquence intermédiaire par les techniques dites de sous-échantillonnage. Le convertisseur CAN a alors une double fonction : d'une part, elle permet, grâce au sous-échantillonnage, d'extraire parmi les répliques du signal celle qui se trouve en bande de base (première zone de Nyquist), ce qui correspond à un changement de fréquence, et d'autre part elle délivre cette réplique en bande de base sous forme numérisée.

Conformément à l'invention, la sortie Y du CAN 20 est traitée par une unité d'alignement temporel 22 avant d'être fournie à la deuxième entrée 4c de l'unité de pré-distorsion numérique 4. L'unité d'alignement temporel 22 a pour fonction d'éliminer les erreurs d'alignement temporel du signal Y vis-à-vis du signal X provenant de la source 6 (présentés à l'entrée respectives 22a), et ce de manière adaptative, ce qui permet de suivre des évolutions et dérives des temps de propagation de la chaîne, par exemple provoquées par les variations de température, le vieillissement, les conditions d'utilisation, etc.. Dans ce cas, on réalise dynamiquement l'apprentissage des décalages temporels et de phase entre les signaux X et Y, de façon à pouvoir recaler numériquement les échantillons entre eux et ainsi obtenir la comparaison dans des conditions optimales au sein de l'unité de pré-distorsion numérique 4. L'unité d'alignement temporel 22 fonctionne en deux étapes :
- une première étape d'alignement temporel grossier, à laquelle elle soumet le signal (X) avant amplification à un retard composé d'un nombre entier de premières unités de temps, et détermine la valeur de ce retard qui produit le signal avant amplification retardé (XR) ayant le meilleur alignement temporel avec le signal (Y) prélevé et numérisé après amplification, et
- une deuxième étape d'alignement temporel fin, à laquelle elle rapproche le signal avant amplification retardé (XR) ayant le meilleur alignement temporel et ledit signal (Y) après amplification de l'amplificateur,
les signaux ainsi rapprochés finement étant utilisés pour établir la pré-distorsion.

A la première étape, l'unité d'alignement temporel produit plusieurs répliques du signal X sous forme retardée XR, avec des retards distincts. Le pas entre chaque retard successif peut correspondre à une première unité, celle-ci étant typiquement d'une période d'échantillonnage du signal X' au niveau du CNA 8 . Chaque réplique est disponible pour comparaison de son alignement temporelle avec le signal Y. L'unité d'alignement temporelle 22 détermine alors laquelle de ces répliques XR du signal retardé a le retard qui se rapproche le plus de celui occasionné par la chaîne d'amplification 12. Cette phase produit une première approximation de corrélation temporelle avec un grain - ou précision - égal à la ± 0,5 fois la première unité temporelle. Cette réplique XR ayant le meilleur alignement temporel avec le signal (Y) après amplification est alors utilisée pour être soumis en entrée de comparaison (troisième entrée 4d) de l'unité de pré-distorsion numérique 4. Par contraste avec le schéma classique de la figure 1, l'unité de pré-distorsion numérique 4 ne se sert plus du signal X de la source 6 comme base de comparaison, présenté à la première entrée 4a, mais du signal XR présenté à cette troisième entrée 4c. On note cependant que cette première 4a est toujours utilisée pour appliquer le signal de la source 6 destiné à recevoir la pré-distorsion.

La deuxième phase intervient pour déplacer finement l'instant d'échantillonnage du signal Y afin de la caler sur celle de la réplique XR avec le meilleur alignement temporel. Pour ce faire, l'unité d'alignement temporel 22 joue sur la phase φvar du signal périodique d'échantillonnage, qui est alors variable, appliqué à l'entrée d'horloge d'échantillonnage Eφ du convertisseur CAN 20.

La nature variable de la phase du signal d'échantillonnage φvar demande que celui-ci soit produit séparément du signal d'échantillonnage pour le convertisseur CNA 8, qui doit être de fréquence et de phase constante, tout en conservant un parfait asservissement fréquenciel long terme entre les deux signaux. Il est ainsi prévu deux circuits d'horloge PLL, 24 et 26, fournissant le signal d'échantillonnage respectivement aux convertisseurs CAN 20 et CNA 8.

Dans l'exemple, la variation de la phase du signal d'échantillonnage φvar du convertisseur CAN 20 est obtenue par variation de la fréquence du signal de référence φvar.réf de son PLL 24. Ce dernier, par son filtre de boucle, joue un rôle d'intégrateur de sorte qu'une impulsion de fréquence autour de la valeur nominale N du rang du diviseur provoque un décalage de phase de φvar. Ce signal de référence variable φvar-réf est produit en sortie d'un diviseur N/N+1/N-1 28 dont la valeur de division N, qui permet la variation de fréquence, est programmable à partir d'une sortie 22c de l'unité d'alignement temporel 22, sachant que la valeur moyenne en régime établit est toujours N.

Le signal d'horloge en entrée du diviseur 28, qui constitue la source du signal φvar-réf, est le signal d'échantillonnage φéch du CNA 8 produit par le PLL 26. On a ainsi la condition : Fréquence φvar.réf = Fréquence φéch/N.

Ainsi, un alignement fin est obtenu en décalant proportionnellement la phase du signal φvar du convertisseur CAN 24 en changeant la phase de l'horloge de référence φvar.réf de son PLL, assurant un verrouillage de phase entre les horloges des deux convertisseurs 8 et 20.

La fréquence d'échantillonnage au niveau du convertisseur CAN 20 peut être typiquement de l'ordre de 100 MHz, voire plus. Cela nécessite des horloges d'échantillonnage avec une bonne pureté spectrale, obtenues à partie d'un PLL ayant une horloge de référence qui donne la référence temporelle et qui assure le filtrage et la pureté spectrale.

Il est donc avantageux d'utiliser comme référence pour le PLL 24 du convertisseur CAN 20 un signal issu du diviseur qui est attaqué par la sortie du PLL 26 du convertisseur CNA 18, car on obtient ainsi une précision importante car une entrée haute fréquence permettant d'avoir une plus grande précision et vitesse dans cet alignement temporel fin pour une commande N-1 ou N+1 du diviseur 28.

Afin d'obtenir un pas relativement fin dans le contrôle de cette référence, on utilise une horloge qui est rapide, ce que fournit utilement le PLL 26. La précision absolue de réglage reste dans l'environnement numérique. Cependant, la phase est contrôlée de façon continue du fait que l'on a un PLL 24 avec un filtre de boucle. Il n'y a donc pas de limite due au pas de quantification absolu dans le réglage au niveau du PLL 24. La seule limitation à cause de la valeur maximum N+1 du diviseur est dans la correction instantanée, autrement dit dans l'impulsion de changement de fréquence que l'on va injecter, liée au rang du diviseur. Plus le diviseur N est grand, plus le pas sera fin, et moins le PLL aura d'effort de filtrage à effectuer, mais en contre-partie, le temps de convergence sera d'autant plus long. Le compromis est entre le temps de convergence et le bruit résiduel lorsque la boucle est verrouillée.

On note que pour des raisons de simplification de coûts et de mise en oeuvre, le signal Y en sortie du récepteur de mesure et du CAN peut être sous échantillonné par rapport au signal X de la source. Pour ce dernier, on utilise par contre - du principe de pré-distorsion - un sur-échantillonnage par rapport à la bande passante du signal à émettre afin de contrôler les harmoniques élevées en opposition de phase. Ceci implique une bande passante large, la fréquence d'échantillonnage étant par exemple supérieur par un facteur de 5 ou 7 à la bande passante à émettre. Cependant, le mode de réalisation de l'invention permet aussi de réduire les contraintes pour la vitesse d'échantillonnage du signal Y , et donc de réduire le coût du convertisseur CAN 20 et les coûts de calcul. au sein de l'unité d'alignement temporel 22. Ce qui compte est essentiellement la précision de l'instant et de l'amplitude du prélèvement Y. Moins on prélève fréquemment Y et plus il faudra de temps pour apprendre la prédistorsion, la vitesse de convergence des tables de prédistorsion étant liée à la quantité totale d'information prélevée et utilisée sur Y.

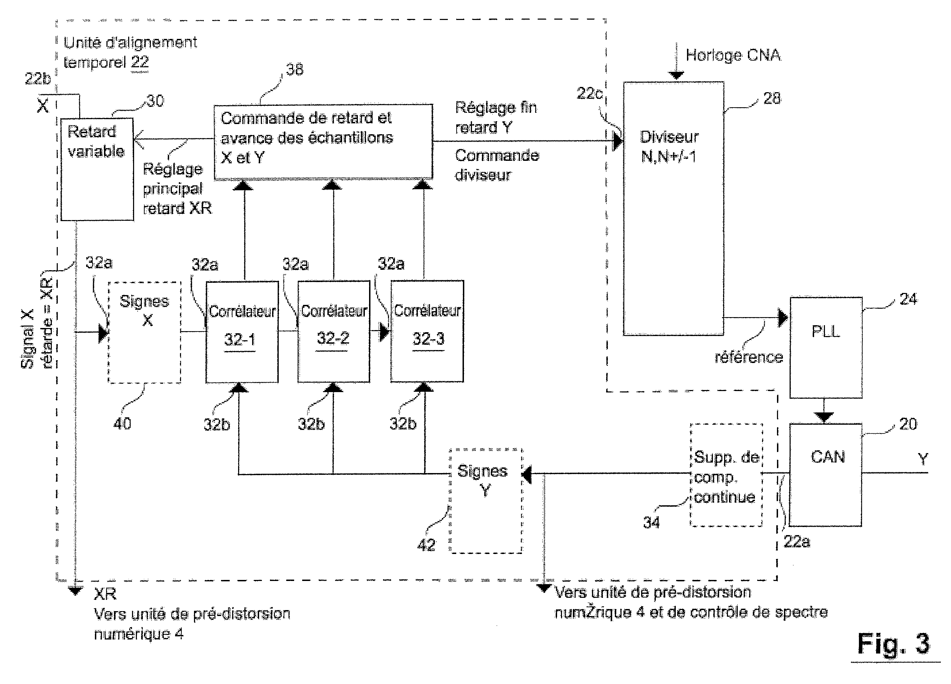

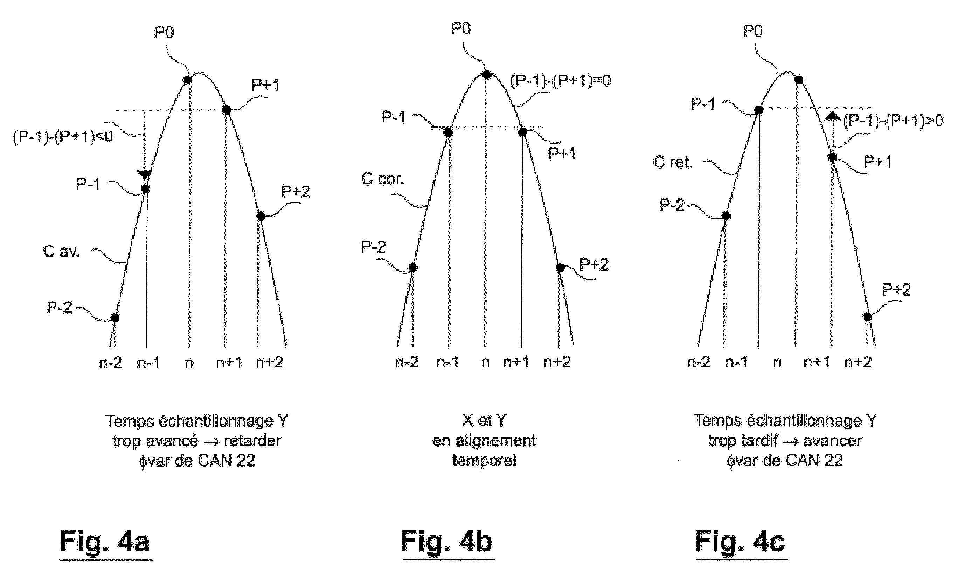

Les éléments fonctionnels de l'unité d'alignement temporel permettant de réaliser ces deux étapes sont décrits plus en détail par référence aux figures 3 et 4.

Ainsi que le montre la figure 3, l'entrée 22b de l'unité d'alignement temporel 22 reçoit le signal numérique X de la source 6 sur un dispositif 30 de retardement variable par pas d'un nombre entier d'échantillons de ce signal, s'agissant par exemple de registres à décalage en nombre variable. Le pas correspond ainsi à la première unité de retard précitée. Le retard ainsi imposé au signal X est prévu pour être au moins égal au retard maximal occasionné par la chaîne d'amplification et de mesure qui produit le signal Y. Le dispositif de retard 30 fournit trois répliques signal XR à une première entrée respective 32a de trois corrélateurs 32-1, 32-2 et 32-3, chacun avec un retard différent, par exemple en les alimentant sur des sorties latérales respectives du registre à décalage. L'intervalle de temps entre les retards successifs fournis aux corrélateurs est supérieur à deux périodes d'échantillonnage du convertisseur CAN 20 pour une valeur moyenne du signal φvar en mode alignement fin.

Les trois corrélateurs fonctionnent ainsi en parallèle, fournissant à un moment donné trois points de corrélation. On peut obtenir plus de points de corrélation en les faisant fonctionner selon un mode parallèle-série, où une opération d'obtention de trois points de corrélation est répétée avec trois nouvelles valeurs de retard, permettant ainsi d'obtenir un multiple de trois points de corrélation. Bien entendu, le nombre de corrélateurs utilisés est arbitraire.

Le nombre de points de corrélation ainsi établis peut être différente entre la première étape d'alignement grossier et la seconde étape d'alignement fin.

La sortie Y du CAN 20 est fournie en parallèle à une seconde entrée respective 32b de chacun de trois corrélateurs (désignation générique 32).

Chaque corrélateur établit alors l'intercorrélation entre le signal Y et le signal retardé XR avec le retard qui lui est spécifique, ce qui permet de travailler en parallèle avec trois hypothèses de décalage consécutifs (ou plus) en phase d'alignement grossier.

On rappelle que le module ou la puissance d'intercorrélation de deux signaux, en l'occurrence Y et X, est une fonction du décalage entre ces deux signaux qui donne une métrique de la ressemblance des signaux pour chaque alignement testé. Dans le mode échantillonné, ce qui est la cas dans le mode de réalisation, un point de corrélation P(k) (cf. figure 4) est la somme des produits croisés des échantillons décalés des signaux X et Y, soit : P(k) = X(0)*Y(k)+X(1)*Y(k+1)+....+X(n)*Y(k+n), si la corrélation est limitée à un support temporel fini d'une longueur de N échantillons.

Pour le cas de signaux X et Y complexes, le point de corrélation P est une fonction complexe du décalage k entre les trains X et Y, dont le module représente la puissance de corrélation et la phase représente la rotation de phase moyenne en les signaux X et Y.

Plus particulièrement, la représentation réelle ou complexe du signal Y est comparée, par corrélations, au signal émis X complexe avec différents retards imposés, de manière à ce que le pic d'intercorrélation soit à l'intérieur de la fenêtre du corrélateur (au moins trois ou cinq points, chacun espacé par une période d'échantillonnage).

Durant cette recherche, on extrait les points de corrélation obtenus à partir des corrélateurs. Dans la figure 4, ces points de corrélation sont au nombre de cinq, s'agissant par exemple d'une sélection parmi six points de corrélation extraits d'un fonctionnement parallèle-série des trois corrélateurs 32-1, 32-2 et 32-3 de la figure 3, chacun de ces derniers produisant deux points de corrélation pour deux valeurs décalages temporel respective.

La comparaison est réalisée en comparant le carré des modules des points de corrélation considérés.

A partir de la réplique du signal XR retardé avant amplification l'échantillon qui donne le maximum de corrélation, on passe à la seconde phase, qui agit sur la chaîne hybride analogique et numérique pour corriger la phase de l'horloge d'échantillonnage φvar pour réaliser l'interpolation de façon analogique et peut coûteuse.

Plus particulièrement, on agit sur le diviseur par N programmable 28 qui commande l'effet différentiateur/intégrateur du PLL pour le caler de façon asservie. L'asservissement fait que l'interpolation, en jouant sur le décalage d'horloge, n'est pas en boucle ouverte.

Il a été vérifié que la courbe de corrélation sur un grand horizon est en forme de cloche où il existe un relation de signe. La largeur de la cloche ainsi que sa pente dépendent à la fois de la quantification de X et Y (signes uniquement ou aussi mantisse) ainsi que du type de modulation et nombre de porteuses et largeur de bande du signal. Ce phénomène est illustré par les figures 4a, 4b et 4c, dont :
- la figures 4a représente une courbe de corrélation Cret. pour le cas d'un temps d'échantillonnage du signal Y trop avancé, ce qui impose de retarder le signal φvar,
- la figure 4c représente un courbe de corrélation Cav. pour le cas d'un temps d'échantillonnage du signal trop tardif, ce qui impose d'avancer le signal φvar, et
- la figure 4b représente la courbe de corrélation Ccor. pour le cas des signaux en alignement temporel, i.e. quand le calage fin est réalisé.

Ces courbes sont produites à partir de points d'intercorrélation P*conjP homogènes à une puissance fonction du décalage k et indépendant des rotations de phase.

Du fait que la courbe de corrélation est relativement pointue et monotone de part et d'autre du vrai sommet, on peut déterminer la direction du changement de la phase et fréquence du signal φvar en fonction du signe du contraste de corrélation, i.e. entre les différences de valeur de corrélation immédiatement à gauche et immédiatement à droite (respectivement les points P-1 et P+1) autour du maximum imparfait relevé (point P0). Dans cette représentation, le point P0 correspond à la meilleure corrélation obtenue durant la première phase d'alignement temporel grossier, et les points P-1 et P+1 correspondent aux meilleures corrélations hormis celle du point P0. Ainsi, avec seulement l'information sur le signe de la différence entre la corrélation à gauche et à droite du maximum, on peut faire converger l'alignement systématiquement dans le bon sens, cette convergence étant obtenue par des pas successifs d'augmentation/de baisse de fréquence de φvar réf et donc de la phase de l'horloge d'échantillonnage du convertisseur CAN 20 par le compteur N-1/N/N+1 et le PLL 24.

Par exemple, dans le cas de la figure 4a, le point de corrélation P+1 à droite du point maximum P0 est plus proche du sommet de la courbe Cret. que ne l'est le point de corrélation P-1 a gauche du point maximum, soit (P-1) - (P+1) < 0, ce qui donne un signe de corrélation désigné "négatif".

A l'inverse, dans le cas de la figure 4c, le point de corrélation P+1 à droite du point maximum P0 est plus éloigné du sommet de la courbe Cav. que ne l'est le point de corrélation P-1 a gauche du point maximum, soit (P-1) - (P+1) > 0, ce qui donne un signe de corrélation désigné "positif".

Bien entendu, les signes de corrélation "négatif" et "positif" doivent être compris comme des entités relatives, fixées par le choix arbitraire consistant à prendre le point de corrélation à gauche (P-1) comme point de référence.
. Les signes ainsi produits sont détectés périodiquement par l'unité générale de commande 38 qui détermine la valeur de division N, N+1 ou N-1 du compteur, de façon à agir :
   - en augmentant la valeur N, pour réduire la fréquence du signal φvar et donc retarder sa phase, tant que le signe détecté est "négatif", et
   - en diminuant la valeur N, pour augmenter la fréquence du signal φvar et donc avancer sa phase, tant que le signe détecté est "positif".

Cette commande est poursuivie en boucle, avec révision à chaque fois de la valeur N jusqu'à obtention de la condition d'alignement temporel des signaux XR et Y, soit (P-1) = P(+1) (figure 4b). Pour éviter des phénomènes d'oscillation ou de chasse dans la boucle de commande, on peut définir un plage de tolérance autour de l'alignement temporel absolu, à l'intérieur de laquelle l'unité commande 38 cesse de modifier la valeur de N, cela a pour effet positif d'ouvrir l'asservissement tant que le désalignement est en dessous d'un seuil fixe et d'améliorer le spectre de l'horloge du CAN, la boucle 24 étant non perturbée. A contrario l'alignement ne se ré-asservira que lorsque le décalage du signal Y par rapport au signal XR sera mesurable ((P-1)-(P+1) non nul).

Chaque changement de la valeur de N peut être d'une ou de plusieurs unités, selon la vitesse de convergence et la précision voulue par exemple jusqu'à N-2 et N+2.

Il a été vérifié que la boucle de commande de la valeur N converge bien même quand la pré-distorsion est très mal calibrée, c'est-à-dire lorsque l'amplificateur sature et intermodule, et que les signaux XR et Y sont de ce fait moins corrélés et la courbe de corrélation un peu plus plate et bruitée.

Une application simplifiée mais très efficace consiste à calculer les trois corrélations sur un horizon de N ou N-1 échantillons, et cela systématiquement, et d'aligner cette fenêtre de corrélation sur le comptage du diviseur N/N-1/N+1.

La boucle d'alignement fin est du type de boucle verrouillée en temps. Elle est capable de suivre les retards dans la fenêtre de +/-0,5 échantillons (et même jusqu'à quasiment +/-1 échantillon, ce qui évite pour les fortes variations de retoucher au calage grossier par le l'unité de retardement principal 30. En parallèle, le pic de corrélation est suivi parmi les trois points de corrélation sélectionnés pour assurer la convergence et réactiver si besoin l'étape 1 de calage principal.

La corrélation complexe-complexe des deux signaux comparés, XR et Y, permet de s'affranchir d'une différence de phase et de gain fixe entre les deux signaux, d'autant qu'on compare les puissances de corrélation.

On peut néanmoins envisager de n'utiliser qu'une représentation réelle du signal Y, pour simplifier les corrélateurs 32 en réduisant d'un facteur deux la sensibilité du détecteur du sens de correction, mais sans créer d'ambiguïté sur les décisions ni de risques de divergence, pourvu que XR reste complexe.

On peut ainsi utiliser pour la corrélation la sortie directe du convertisseur CAN 20 sans le convertir en signal complexe ce qui rend plus intéressant encore le sous-échantillonnage naturel en fréquence intermédiaire avec un seul CAN réel.

Cette simplification des corrélateurs 32 augmente le temps de convergence à quelques dizaines de millisecondes, voire centaines de millisecondes, mais reste compatible avec une durée initiale de calibration faible devant les temps de mise en route du système et avec les variations lentes dues essentiellement aux variations thermiques et au vieillissement.

Au besoin, le signal Y en sortie du CAN 20 peut être soumis à une suppression de composante continue (unité 34 représenté en lignes pointillées).

Le signal Y après traitement par l'unité d'alignement temporel 22, est donc réaligné temporellement e avec le signal XR. Ce signal aligné Y est alors fourni à l'entrée de comparaison 4c de l'unité de pré-distorsion numérique 4 (cf. figure 2) tout comme le signal XR qui est fourni à une troisième entrée 4d de cette unité.

Dans une variante possible du mode de réalisation, il est possible de simplifier les corrélateurs et de normaliser les valeurs de corrélation en ne prenant en considération seulement le signe arithmétique des signaux XR et Y. A cette fin, on prévoit une première et seconde unités de détection de signes 40 et 42 en amont respectivement des première et seconde entrées 32a et 32b des corrélateurs 32. (S'agissant d'éléments optionnels, ces unités 40 et 42 sont représentées en lignes pointillées.) Conformément à cette variante, on se limite à des valeurs de coïncidence entre les signaux XR et Y, c'est-à-dire que les unités de détection de signe 40 et 42 se bornent à prélever le signe des signaux. En représentation numérique classique, cette opération se résume avantageusement à calculer en "complément à 2", en ne prenant que le bit de poids fort, qui représente le signe. Dans le cas d'un signal complexe, cette opération est réalisée indépendamment sur les composantes I et Q, ce qui revient à représenter le signal considéré par quatre valeurs possibles, qui correspondent aux sommets respectifs d'un carré : 1+j, 1-j, -1+j et-1-j.

Bien entendu, on peut également envisager toute solution intermédiaire selon laquelle on tronc ou on arrondie la représentation de valeurs des signaux XR et Y.

On comprendra que la complexité et la dynamique des corrélateurs suit celle des signaux XR et Y en aval des unités de détection de signe 40 et 42.

Bien que le mode de réalisation de l'invention puisse être mis en oeuvre avec de nombreuse techniques connues de pré-distorsion, celles pour laquelle il est particulièrement avantageux est de classe adaptative à récepteur large bande, telles que les algorithmes LMS, où on réalise la mise à jour et l'apprentissage des tables de pré-distorsion par une comparaison en temps réel du signal émis et reçu et ceci pour chaque échantillon émis et reçu (ou bien pour chaque échantillon reçu si le CAN tourne à un rythme sous harmonique du flot du signal X).

Grâce à l'invention, on peut réaliser en parallèle et en permanence à la fois la pré-distorsion et la calibration des tables d'apprentissage, ces paramètres coopérant de manière positive. La robustesse de la technique de l'invention assure qu'il y a calibration même lorsque l'on met en route le système et que l'on a perdu toute mémoire de pré-distorsion, ce qui amène l'amplificateur de puissance à 12 être en régime proche de la saturation. On n'a donc pas besoin d'un signal de test, puisque la technique fonctionne au fil de l'eau sur le signal nominal d'amplification qu'il soit faible ou fort. On diffère donc des méthodes classiques de calibration qui nécessitent des arrêts d'émission périodiques sur la station pour injecter un signal de test bien défini servant de référence pour la calibration. La station peut ainsi rester disponible en permanence.

En effet, le procédé d'alignement temporel et d'apprentissage par corrélation utilisent uniquement les propriétés des corrélation et une certaine symétrie de corrélation qui sont vérifiées pour n'importe quel signal, donc aussi par le signal utile d'émission de la station.

On note que l'alignement temporel et l'apprentissage interagissent positivement l'un envers l'autre. En effet, plus on "calibre", plus les tables de pré-distorsion vont converger rapidement vers la bonne valeur, avec un plancher de bruit résiduel qui est faible; réciproquement, plus la pré-distorsion est bonne, plus le sommet de courbe C (figures 4a-c) de corrélation est pointu et le plancher bas, et la précision sur le signe devient beaucoup moins sensible au bruit d'intermodulation résiduel de l'amplificateur.

L'invention présente de nombreux avantages dans une application d'amplification avec pré-distorsion adaptative, dont :
- de permettre d'utiliser l'horloge PLL existante 26 à la fois pour le convertisseur CNA 8 émetteur et pour le convertisseur CAN 20 récepteur, où elle sert de source de fréquence de référence pour le PLL 24 du convertisseur CAN ;
- de n'utiliser seulement des données numériques de réception et de transmission existantes pour assurer un étalonnage permanent et complet sans signal de test;
- de permettre d'intégrer quasiment tous les éléments supplémentaires numériquement et ce aisément sur réseau logique programmable par l'utilisateur (connu par l'acronyme anglo-saxon de FPGA pour "field programmable gate array") ou sur un circuit intégré à application spécifique (connu par l'acronyme anglo-saxon ASIC pour "application specific integrated circuit"), seulement quelques milliers de portes étant nécessaires aux fonctions de calibration temporelle;
- les PLL sont aussi potentiellement intégrables ainsi que les compteurs
- d'être compatible avec tout type de pré-distorsion adaptatif numérique avec rebouclage dans le domaine temporel ;
- d'offrir une précision de l'alignement temporel qui peut être accrue lorsque nécessaire (cas de porteuses multiples) grâce à un contraste de corrélation plus aigu ;
- d'être compatible avec les solutions de corrélation simplifiées : d'une corrélation de signe à des multiplicateurs tabulés de quelques bits.
   Remarque : dans le cas où la corrélation se limite à des corrélations de signes i.e. les signaux XR & Y représentés par le signe de leurs parties réelles et imaginaires, la corrélation n'est qu'un jeu de compteurs /décompteurs alimenté par des « ou exclusifs sur les signes ». La puissance de corrélation n'est plus que la somme des carrés des compteurs.
   L'avantage est qu'ainsi les valeurs de corrélations sont équivalentes à des taux de coïncidence de signe entre les signaux XR et Y et sont insensibles à la phase relative, mais surtout à la puissance de chaque signal. Cela facilite le contrôle du gain de la boucle de commande d'une part et rend la courbe de corrélation plus abrupte et plus indépendante des distorsions (autrement dit, si l'amplificateur de puissance 12 sature, cela ne change pas ou peu le signe de Y ni ses instants de passage par zéro) ;
- de permettre d'affiner et de mettre en oeuvre les critères pour les paramètres de boucle sous forme logicielle dans un processeur de signal numérique ou un microcontrôleur, du fait de la moyenne vitesse de l'ensemble de la boucle de contrôle ;
- de permettre un convergence de l'alignement temporel avant que la pré-distorsion ne soit activée ou démarrée, grâce à la robustesse des corrélateurs et à la métrique utilisée pour commander la PLL 24 (remarque plus haut).
- de permettre, grâce à l'alignement initial par un nombre entier de retards d'échantillons, d'éviter de recourir à tout étalonnage en usine, même si le retard total de transmission et de réception est inconnu ou présente une variation de plus d'une période ;
- de maintenir l'alignement temporel effectif (par utilisation de contraste de corrélation normalisée) même lors de périodes de faible puissance d'émission (remarque plus haut);
- de détecteur les problèmes de convergence par une courbe de corrélation trop plate, permettant ainsi d'obtenir un moyen de protéger la table DPD de mises à jour inutiles ou dangereuses parce qu'entachées d'erreur de désalignement.

L'invention s'applique entre autres à toutes les normes à porteuse unique ou multiple 3G/CDMA. Elle s'applique par principe aux amplificateurs linéarisés pour des radiodiffusions fixes sans fil jusqu'aux modulations large bande telles que la CDMA ou OFDM. Dans cette application, elle exploite ainsi avantageusement les propriétés de pseudo bruit et de bande large des signaux CDMA à porteuse unique et multiple.

On comprendra que l'invention autorise de nombreuse autres variantes sans sortir du cadre des revendications, tant au niveau de sa mise oeuvre matérielle et fonctionnelle qu'au applications visées.

La description est basée sur une application dans le contexte d'une chaîne d'amplification d'une station émettrice utilisant les techniques de pré-distorsion. Cependant, il est clair que l'alignement temporel enseigné par l'invention s'applique à tous les domaines techniques qui peuvent bénéficier d'un calage temporel de plusieurs signaux.

## Revendications

1. Procédé de préparation de signaux (respectivement X et Y) destinés à être comparés pour établir une pré-distorsion sur l'entrée d'un amplificateur (12), les signaux comprenant un signal (X) avant amplification et un signal (Y) après amplification par ledit amplificateur,
**caractérisé en ce que** ladite préparation comprend un alignement temporel (22) entre les signaux avant amplification et après amplification (respectivement X et Y) avant de les utiliser pour établir ladite pré-distorsion.

2. Procédé selon la revendication 1, **caractérisé en ce qu'**il comprend
- une première étape d'alignement temporel grossier, à laquelle on soumet le signal (X) avant amplification à un retard composé d'un nombre entier de premières unités de temps, et on détermine la valeur de ce retard qui produit le signal avant amplification retardé (XR) ayant le meilleur alignement temporel avec le signal (Y) après amplification, et
- une deuxième étape d'alignement temporel fin, à laquelle on détermine une valeur de retard ou d'avance, d'une fraction de la première unité de temps, à appliquer au signal (Y) prélevé après amplification permettant d'obtenir le meilleur alignement temporel avec le signal avant amplification retardé (XR), et on applique cette valeur de retard ou d'avance au signal après amplification,
les signaux (Y, XR) ainsi rapprochés en temps étant utilisés pour établir ladite pré-distorsion.

3. Procédé selon la revendication 2, **caractérisé en ce que** l'on présente lesdits signaux avant amplification et après amplification (respectivement X et Y) sous forme numérique à ladite première étape d'alignement temporel.

4. Procédé selon la revendication 2 ou 3, **caractérisé en ce que** l'on détermine le signal avant amplification retardé (XR) ayant le meilleur alignement temporel et/ou ladite fraction de la première unité de temps par analyse (32) de points de corrélation (P) entre d'une part le signal avant amplification retardé (XR) et d'autre part le signal (Y) après amplification de l'amplificateur, ledit signal avant amplification retardé ayant le meilleur alignement temporel étant identifié comme celui offrant les points de corrélation les plus élevés.

5. Procédé selon la revendication 4, **caractérisé en ce que** l'on réalise ladite analyse de points de corrélation (P) sur plusieurs formes retardées distincte du signal avant amplification retardé (XR), présentées en parallèle pour ladite analyse (32-1, 32-2, 32-3), le signal avant amplification retardé (XR) ayant le meilleur alignement temporel étant sélectionné parmi ces formes distinctes du signal avant amplification retardé.

6. Procédé selon l'une quelconque des revendication 4 ou 5, **caractérisé en ce que** l'on réalise ladite analyse de points de corrélation (P) sur la base de la représentation complexe d'au moins l'un des signaux (XR,Y) soumis à la corrélation.

7. Procédé selon l'une quelconque des revendication 4 à 6, **caractérisé en ce que** l'on réalise ladite analyse de points de corrélation (P) sur la base de la représentation complexe, i.e. des parties réelle et imaginaire, dudit signal avant amplification retardé (XR) et sur la représentation réelle seulement du signal (Y) après amplification.

8. Procédé selon l'une quelconque des revendications 2 à 7, **caractérisé en ce que** l'on numérise (20) le signal (Y) après amplification, avant ladite première étape, à une première fréquence d'échantillonnage (ϕvar) en relation harmonique avec celle du signal (X) avant amplification.

9. Procédé selon l'une quelconque des revendications 4 à 8, **caractérisé en ce que** l'on définit, pour ledit signal avant amplification retardé (XR) ayant le meilleur alignement temporel, une courbe de corrélation (C) à l'aide d'au moins trois points de corrélation (P-1), P(0), (P+1), dont un premier point de corrélation (P0) correspondant à la valeur de corrélation la plus élevée des points de corrélation (P), et un deuxième et un troisième points de corrélation (P-1) et P(+1) respectivement de part et d'autre du premier point de corrélation, et **en ce que** le rapprochement des instants d'échantillonnage des signaux (XR, Y) lors de la seconde étape d'alignement phase d'alignement temporel est réalisé en :
- retardant l'instant d'échantillonnage du signal (Y) après amplification de l'amplificateur (12) relativement au signal (XR) avant amplification retardé si le deuxième point de corrélation (P-1) présente un niveau de corrélation inférieur à celui de troisième point de corrélation (P+1), (figure 4a), et en
- avançant l'instant d'échantillonnage du signal (Y) après amplification de l'amplificateur (12) relativement au signal (XR) avant amplification retardé si le deuxième point de corrélation (P-1) présente un niveau de corrélation supérieur à celui de troisième point de corrélation (P+1) (figure 4c),
ou inversement,
de manière à converger vers un niveau de corrélation sensiblement égal entre les deuxième et troisième points de corrélation (P-1) et (P+1) (figure 4b).

10. Procédé selon l'une quelconque des revendications 4 à 9, **caractérisé en ce que** la détermination de corrélation est établie en ne prenant en compte que les signes (40, 42) d'une part du signal avant amplification retardé (XR) et d'autre part du signal (Y) après amplification de l'amplificateur, ladite corrélation étant basée sur des calculs de coïncidence de signes entre ces deux signaux (XR, Y).

11. Procédé selon l'une quelconque des revendications 2 à 10, **caractérisé en ce** l'on numérise ledit signal (Y) après amplification à une fréquence d'échantillonnage contrôlée en phase (φvar), ladite deuxième étape consistant à faire varier cette phase d'échantillonnage sélectivement pour accroître l'alignement temporel dudit signal avant amplification retardé (XR) ayant le meilleur alignement temporel et dudit signal (Y) après amplification de l'amplificateur.

12. Procédé selon la revendication 11, **caractérisé en ce que** l'on produit ladite première fréquence d'échantillonnage contrôlée en phase (φvar) en sortie d'une première boucle à verrouillage en phase (24), 1a variation étant obtenue en variant de façon impulsionnelle la fréquence de référence (φvar.réf) de cette boucle.

13. Procédé selon la revendication 12, **caractérisé en ce que** l'on produit ladite fréquence de référence (φvar.réf) de la première boucle à verrouillage en phase (24) au moyen d'une seconde boucle à verrouillage en phase (26), après division de fréquence (28) de sa fréquence de sortie (φéch) par un nombre diviseur (N) variable, ladite variation de la fréquence de référence (φvar.réf) de la première boucle à verrouillage en phase (24) étant produite par changement du nombre (N) pour obtenir ledit rapprochement des phases dudit signal avant amplification retardé (XR) ayant le meilleur alignement temporel et dudit signal (Y) après amplification.

14. Procédé selon la revendication 13, **caractérisé en ce que** l'on réalise la conversion numérique-analogique (8) du signal (X) avant amplification avant de la fournir en entrée de ce dernier, la conversion étant cadencée par un signal d'échantillonnage (φéch) produit en sortie de ladite seconde boucle de verrouillage en phase (26).

15. Dispositif de préparation de signaux (respectivement X et Y) destinés à être soumis à des moyens de pré-distorsion agissant sur l'entrée d'un amplificateur (12), les signaux comprenant un signal (X) avant amplification et un signal (Y) après amplification par ledit amplificateur,
**caractérisé en ce qu'**il comprend des moyens (22) d'alignement temporel entre les signaux avant amplification et après amplification (respectivement X et Y).

16. Dispositif selon la revendication 15, **caractérisé en ce qu'**il comprend :
- des premiers moyens d'alignement temporel grossier (30, 32, 38) pour soumettre le signal (X) avant amplification à un retard composé d'un nombre entier de premières unités de temps, et pour déterminer la valeur de ce retard qui produit le signal avant amplification retardé (XR) ayant le meilleur alignement temporel avec le signal (Y) après amplification, et
- des deuxièmes moyens d'alignement temporel fin, pour déterminer une valeur de retard ou d'avance, d'une fraction de la première unité de temps, à appliquer au signal (Y) prélevé après amplification permettant d'obtenir le meilleur alignement temporel avec le signal avant amplification retardé (XR), et pour appliquer cette valeur de retard ou d'avance au signal après amplification,
les signaux ainsi rapprochés en temps étant fournis auxdits moyens de pré-distorsion.

17. Dispositif selon la revendication 16, **caractérisé en ce que** les premiers moyens et/ou deuxièmes moyens comprennent des moyens (32) d'analyse de points de corrélation (P) entre d'une part le signal avant amplification retardé (XR) et d'autre part le signal (Y) après amplification de l'amplificateur pour déterminer le signal avant amplification retardé (XR) ayant le meilleur alignement temporel, celui-ci étant identifié comme offrant les points de corrélation les plus élevés.

18. Dispositif selon la revendication 17, **caractérisé en ce qu'**il comprend des moyens d'analyse de points de corrélation (P) sur la base de la représentation complexe d'au moins l'un des signaux (XR,Y) soumis à la corrélation.

19. Dispositif selon la revendication 18, **caractérisé en ce que** lesdits moyens d'analyse de points de corrélation (P) opèrent sur la base de la représentation complexe, i.e. des parties réelle et imaginaire, dudit signal avant amplification retardé (XR) et sur la représentation réelle seulement du signal (Y) après amplification.

20. Dispositif selon l'une quelconque des revendications 16 à 19, **caractérisé en ce qu'**il comprend des moyens (20) pour numériser le signal (Y) après amplification, en amont des premiers moyens d'alignement temporel, à une première fréquence d'échantillonnage (ϕvar) en relation harmonique avec celle du signal (X) avant amplification.

21. Dispositif selon l'une quelconque des revendications 17 à 20, **caractérisé en ce qu'**il comprend des moyens de définition, pour ledit signal avant amplification retardé ayant le meilleur alignement temporel, d'une courbe de corrélation (C) à l'aide d'au moins trois points de corrélation (P-1), P(0), (P+1), dont un premier point de corrélation (P0) correspondant à la valeur de corrélation la plus élevée des points de corrélation (P), et un deuxième et un troisième points de corrélation (P-1) et P(+1) respectivement de part et d'autre du premier point de corrélation, et **en ce que** lesdits deuxième moyens de rapprochement des instants d'échantillonnage des signaux (XR, Y) lors de la seconde étape d'alignement phase d'alignement temporel comprennent :
- des moyens pour retarder l'instant d'échantillonnage du signal (Y) après amplification de l'amplificateur (12) relativement au signal (XR) avant amplification retardé si le deuxième point de corrélation (P-1) présente un niveau de corrélation inférieur à celui de troisième point de corrélation (P+1), (figure 4a), et
- des moyens pour avancer l'instant d'échantillonnage du signal (Y) après amplification de l'amplificateur (12) relativement au signal (XR) avant amplification retardé si le deuxième point de corrélation (P-1) présente un niveau de corrélation supérieur à celui de troisième point de corrélation (P+1) (figure 4c),
ou inversement,
de manière à converger vers un niveau de corrélation sensiblement égal entre les deuxième et troisième points de corrélation (P-1) et (P+1) (figure 4b).

22. Dispositif selon l'une quelconque des revendications 17 à 21, **caractérisé en ce qu'**il comprend en outre des moyens de détection de signe (40, 42) d'une part du signal avant amplification retardé (XR) et d'autre part du signal (Y) après amplification de l'amplificateur, permettant la détermination de corrélation en ne prenant en compte que les signes, ladite corrélation étant basée sur des calculs de coïncidence de signe entre ces deux signaux (XR, Y).

23. Dispositif selon l'une quelconque des revendications 16 à 22, **caractérisé en ce qu'**il comprend des moyens pour numériser ledit signal (Y) après amplification à une fréquence d'échantillonnage contrôlée en phase (φvar), lesdits deuxièmes moyens d'alignement temporel comprend des moyens de variation pour faire varier cette phase d'échantillonnage sélectivement pour accroître l'alignement temporel des phases dudit signal avant amplification retardé (XR) ayant le meilleur alignement temporel et dudit signal (Y) après amplification de l'amplificateur.

24. Dispositif selon la revendication 23, **caractérisé en ce qu'**il comprend une première boucle à verrouillage en phase (24) pour produire ladite première fréquence d'échantillonnage contrôlée en phase (φvar), les moyens de variation agissant en variant la fréquence de référence (φvar.réf) de cette boucle.

25. Dispositif selon la revendication 24, **caractérisé en ce qu'**il comprend en outre une seconde boucle à verrouillage en phase (26) pour produire ladite fréquence de référence (φvar.réf) de la première boucle à verrouillage en phase (24) via un diviseur de fréquence (28) par un nombre diviseur (N) variable, lesdits moyens de variation de la fréquence de référence (φvar.réf) de la première boucle à verrouillage en phase (24) étant agissant par changement du nombre (N) pour obtenir ledit rapprochement des phases dudit signal avant amplification retardé (XR) ayant le meilleur alignement temporel et dudit signal (Y) après amplification.

26. Dispositif selon la revendication 25, **caractérisé en ce qu'**il comprend en outre des moyens (8) de conversion numérique-analogique du signal (X) avant amplification dont la conversion étant cadencée par un signal d'échantillonnage (φéch) produit en sortie de ladite seconde boucle de verrouillage en phase (26).

27. Chaîne d'amplification ayant au moins un amplificateur (12) et comprenant des moyens de pré-distorsion (4) acceptant en entrée pour comparaison des signaux respectivement avant et après distorsion par l'amplificateur **caractérisé en ce qu'**il comprend un dispositif d'alignement temporel selon l'une quelconque des revendications 15 à 26 fournissant lesdits signaux (XR et Y) en entrée pour comparaison.

28. Chaîne d'amplification selon la revendication 27, **caractérisée en ce qu'**elle est mise en oeuvre pour une l'amplification de puissance linéaire d'un émetteur hertzien large bande.

29. Chaîne d'amplification selon la revendication 28, **caractérisé en ce que** la bande s'établit sur une fréquence de l'ordre de 10 à 100 MHz, par exemple 60 MHz, et **en ce qu'**elle est destinée à l'émission de signaux a porteuses multiples, par exemple pour l'émission en codage du type dit "à accès multiples à répartition par codes" (AMRC) pour la téléphonie mobile.
